**Europäisches Patentamt**

**European Patent Office**

**Office européen des brevets**

(19)

(11) Veröffentlichungsnummer: **0 215 190**
**B1**

# EUROPÄISCHE PATENTSCHRIFT

(12)

(45) Veröffentlichungstag der Patentschrift:
**10.05.89**

(51) Int. Cl.⁴: **G01R 17/10**

(21) Anmeldenummer: **86106689.2**

(22) Anmeldetag: **16.05.86**

(54) **Schaltungsanordnung zum Abgleich der Messdiagonalspannung einer Widerstandsbrückenschaltung.**

(30) Priorität: **21.08.85 DE 3529824**

(43) Veröffentlichungstag der Anmeldung:
**25.03.87 Patentblatt 87/13**

(45) Bekanntmachung des Hinweises auf die Patenterteilung:
**10.05.89 Patentblatt 89/19**

(84) Benannte Vertragsstaaten:
**DE FR GB NL SE**

(56) Entgegenhaltungen:
**EP-A- 0 009 231**
**DE-A- 2 950 455**
**DE-B- 2 260 439**

(73) Patentinhaber: **Hartmann & Braun Aktiengesellschaft,**
**Gräfstrasse 97, D-6000 Frankfurt am Main 90(DE)**

(72) Erfinder: **Vogt, Reinhard, Dr., Hochstrasse 59,**
**D-6100 Darmstadt(DE)**

## Beschreibung

Die Erfindung bezieht sich auf eine Schaltungsanordnung zum Abgleich der Meßdiagonalspannung einer Widerstandsbrückenschaltung nach der Gattung des Anspruches 1.

Aus der EP-A 0 009 231 ist eine Schaltungsanordnung zur Messung der Meßdiagonalspannung einer Widerstandsbrückenschaltung bekannt, bei der eine zweite willkürlich verstimmbare Widerstandsbrückenschaltung hinsichtlich ihrer Speise- und Meßdiagonalen parallelgeschaltet ist. Als Maß für die Meßdiagonalspannung der ersten Brückenschaltung dient die zum Verschwinden einer gemeinsamen Meßdiagonalspannung notwendige Verstimmung der zweiten Brückenschaltung, die von einem an die gemeinsame Meßdiagonalspannung beider Brückenschaltungen angeschlossenen Nachlaufsystem gesteuert ist. Zu diesem Zweck ist die zweite Widerstandsbrückenschaltung an beiden Speisepunkten aufgetrennt und die Trennstellen mit je einem zusätzlichen Brückenwiderstand überbrückt. Die Anschlüsse der zusätzlichen Widerstände sind durch diagonal umschaltbare Kontakte zweier Umschalter für den Speisekreis verbunden. Das Tastverhältnis der Umschaltfrequenz wird vom Nachlaufsystem gesteuert.

Der Erfindung lag die Aufgabe zugrunde, eine Schaltungsanordnung zum Abgleich der Meßdiagonalspannung einer Widerstandsbrückenschaltung anzugeben, die ohne das Hilfsmittel einer zweiten Widerstandsbrücke als Kompensationseinrichtung auskommt. Der Abgleich soll mit möglichst hoher Auflösung erfolgen und für den Einsatz in einem automatisch arbeitenden Meßgerät ohne mechanisch bewegte Teile geeignet sein. Die Lösung dieser Aufgabe gelingt erfindungsgemäß mit den Merkmalen im Kennzeichen des Anspruches 1.

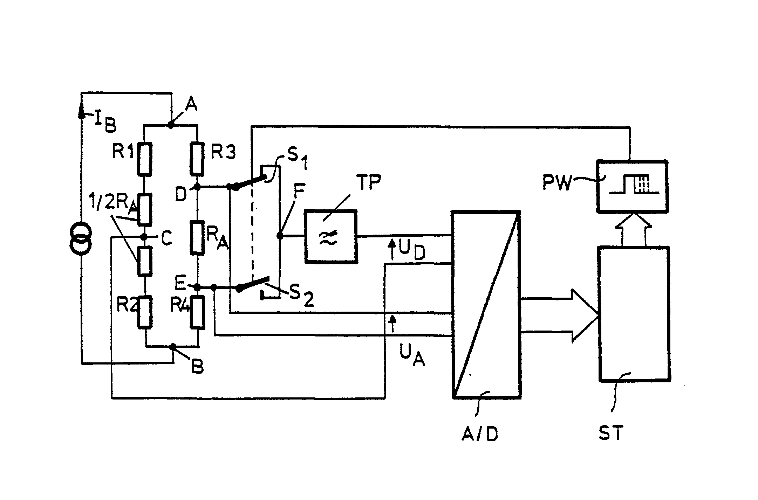

Die Erfindung wird anhand eines in der Figur dargestellten Ausführungsbeispieles näher erläutert.

Die Zeichnung zeigt eine Widerstandsbrückenschaltung mit den Widerständen R1, R2, R3 und R4. An eine erste Brückendiagonale mit den Eckpunkten A und B wird ein Gleichstrom $I_B$ eingespeist. Von den Widerständen R1 bis R4 ist mindestens einer ein Meßfühler, der sich mit der zu messenden Größe ändert.

Der Brückenzweig R3, R4 ist an den Punkten D und E aufgetrennt und mit einem Abgleichwiderstand $R_A$ überbrückt. Aus Gründen der gleichmäßigen Stromaufteilung sind im anderen Brückenzweig R1, R2 zwei in der Summe gleich große Festwiderstände 1/2 $R_A$ eingefügt.

Die Endpunkte D und E des Abgleichwiderstandes $R_A$ sind mit je einem elektronisch steuerbaren Schalter S1 und S2 verbunden, deren ruhende Kontaktteile in Punkt F zusammengeschaltet und mit dem Eingang eines Tiefpasses TP verbunden sind. Die Schalter S1 und S2 werden durch ein digitales Steuersignal abwechselnd gegensinnig ein- und ausgeschaltet. Das Steuersignal liefert ein Pulsweitenmodulator PW. Die zwischen dem Brückenpunkt C und dem Ausgang des Tiefpasses anstehende Meßdiagonalspannung $U_D$ wird dem Eingang eines A/D-Umsetzers A/D zugeführt, der die Meßspannung $U_D$ in einen entsprechenden Digitalwert mit hoher Genauigkeit umsetzt. Der Digitalwert wird einer Steuereinheit ST zugeführt, die ihrerseits das Steuersignal des Pulsweitenmodulators PW beeinflußt. Als Steuereinheit ST kann ein Mikroprozessorbaustein verwendet werden.

Der Abgleich der Meßdiagonalspannung $U_D$ der Widerstandsbrückenschaltung erfolgt in einem digital arbeitenden System, bestehend aus den Schaltern S1 und S2, dem A/D-Umsetzer A/D, der Steuereinheit ST und dem Pulsweitenmodulator PW. Dieses digital arbeitende Abgleichsystem ersetzt ein mechanisch einstellbares Potentiometer durch den Abgleichwiderstand $R_A$, wobei dessen Teilerverhältnis mit Hilfe der beiden Schalter S1 und S2 eingestellt wird. Beide Schalter werden abwechselnd mittels des vom Pulsweitenmodulator PW generierten Steuersignales mit einstellbarem Tastverhältnis periodisch ein- und ausgeschaltet. Ist im Grenzfall der Schalter S1 dauernd geschlossen und der Schalter S2 geöffnet, so stellt sich als Spannungswert $U_D$ die zwischen den Brückenpunkten C und D herrschende Meßspannung ein. Entsprechend erscheint im umgekehrten Grenzfall als Spannungswert $U_D$ die Meßspannung zwischen den Brückenpunkten C und E. Bei einem gegebenen Tastverhältnis des Steuersignales zwischen diesen beiden Grenzfällen stellt sich eine Meßspannung $U_D$ ein, die zwischen den beiden bezeichneten Meßspannungs-Grenzwerten liegt und die linear vom Tastverhältnis abhängig ist. Damit ist der von der Verstimmung der Widerstandsbrückenschaltung abhängige Verstellweg eines analog arbeitenden Abgleichpotentiometers durch das digital einstellbare Tastverhältnis des Steuersignales ersetzt.

Als Steuersignal dient ein Rechtecksignal mit einstellbarem Tastverhältnis, welches der Pulsweitenmodulator PW generiert. Die Einstellung des Tastverhältnisses erfolgt in digitalen Schritten durch die Steuereinheit ST in Abhängigkeit des vom A/D-Umsetzer ermittelten Digitalwertes der Meßspannung $U_D$. Da das Tastverhältnis diskret eingestellt wird, ist auch die Auflösung des digital arbeitenden Abgleichsystems stufig, so daß der gewünschte Brückenabgleich im allgemeinen nicht bis zur Brückendiagonalspannung $U_D$ gleich Null führt. Es verbleibt eine nicht abgleichbare Restabweichung, die mit dem A/D-Umsetzer A/D meßbar ist, so daß der noch verbleibende Abgleichfehler durch Messung ermittelt werden kann.

Die Restabweichung ist linear abhängig von der Größe des Brückenstromes $I_B$. Somit ergibt sich ein Meßfehler, wenn Schwankungen von $I_B$ bei der Ermittlung der Restspannung mit dem A/D-Umsetzer A/D unberücksichtigt bleiben. Wird jedoch die für den A/D-Umsetzer erforderliche Referenzspannung aus der über dem Abgleichwiderstand $R_A$ abfallenden Spannung $U_A$ abgeleitet, so verändert sich bei Schwankungen des Brückenspeisestromes $I_B$ die Kennlinie des Umsetzers. Restabweichung und Referenzspannung sind proportional zu $I_B$, so daß eine Änderung von $I_B$ sowohl bei der Restabweichung als auch bei der Referenzspannung zu einer prozentual gleichen Abweichung führt. Damit ist der Fehlereinfluß von $I_B$ bei der Messung der Restabweichung vollständig kompensiert. Als A/D-Umsetzer sind integrierende Umsetzer geeignet, beispielsweise nach dem Dual-Slope-Verfahren arbeitende Umsetzer.

**Patentansprüche**

1. Schaltungsanordnung zum Abgleich der Meßdiagonalspannung einer Widerstandsbrückenschaltung, bei der mindestens ein Widerstandselement entsprechend einer Meßgröße variabel ist, an eine erste Brückendiagonale ein Versorgungsstrom eingespeist und an einer zweiten Brückendiagonale ein der Meßgröße entsprechendes Signal abgegriffen wird, gekennzeichnet durch die folgenden Merkmale:
   a) die zweite Brückendiagonale ist an einem ihrer beiden Meßpunkte aufgetrennt und die Trennstelle (D, E) mit einem Abgleichwiderstand ($R_A$) überbrückt;
   b) zwei elektronisch steuerbare Schalter (S1, S2) sind jeweils mit einer Seite an einem der Endpunkte des Abgleichwiderstandes ($R_A$) angeschlossen, mit der anderen Seite zusammengeschaltet und mit einem Tiefpaß (TP) verbunden, und
   c) beide Schalter (S1, S2) werden abwechselnd durch ein digitales Steuersignal mit einstellbarem Tastverhältnis periodisch gegensinnig ein- und ausgeschaltet, wobei das Tastverhältnis bei Verschwinden der Meßdiagonalspannung ($U_D$) ein Maß für die Verstimmung der Widerstandsbrückenschaltung ist.

2. Schaltungsanordnung nach Anspruch 1, dadurch gekennzeichnet, daß das Tastverhältnis des Steuersignales von einem Pulsweitenmodulator (PW) erzeugt wird.

3. Schaltungsanordnung nach Anspruch 1 und Anspruch 2, dadurch gekennzeichnet, daß die zwischen dem Ausgang des Tiefpasses (TP) und dem anderen Meßpunkt (C) der zweiten Brückendiagonale vorhandene Meßdiagonalspannung ($U_D$) einem A/D-Umsetzer (A/D) zugeführt ist, dessen digitales Ausgangssignal zur Steuerung des Pulsweitenmodulators (PW) verwendet wird.

4. Schaltungsanordnung nach Anspruch 1 und 3, dadurch gekennzeichnet, daß der A/D-Umsetzer (A/D) ein integrierend arbeitender Umsetzer ist, dem die am Abgleichwiderstand ($R_A$) abfallende Gleichspannung ($U_A$) als Referenzspannung zugeführt ist.

**Revendications**

1. Dispositif de commutation pour l'équilibrage de la tension transversale de mesure d'un circuit à pont de résistances selon lequel un élément résistant correspondant à une grandeur de mesure est variable, sur une première diagonale de pont, on alimente un courant d'alimentation et un signal correspondant à la grandeur de mesure est prélevé, caractérisé par les prescriptions suivantes:

   a) la seconde diagonale de pont est séparée sur un de ses deux point de mesure et les deux positions de séparation (D, E) sont court-circuitées par une résistance d'équilibrage ($R_A$);
   b) deux interrupteurs commandables électroniquement (S1, S2) sont reliés chacun à l'un des points d'extrémité de la résistance d'équilibrage ($R_A$) reliés à l'autre côté et à un filtre passe-bas (TP), et
   c) les deux interrupteurs (S1, S2) sont alternativement ouverts et fermés grâce à un signal de commande numérique, la durée du cycle lors de la disparition de la tension diagonale de mesure ($U_D$) constituant une mesure pour la détermination du circuit à pont de résistances.

2. Dispositif de commutation selon la revendication 1, caractérisé en ce que la durée du cycle du signal de commande est obtenue à partir d'un modulateur de largeur d'impulsions.

3. Dispositif de commutation selon la revendication 1 et la revendication 2, caractérisé en ce que la tension diagonale de mesure ($U_D$) existant entre la sortie du filtre passe-bas (TP) et l'autre point de mesure (C) de la seconde diagonale de pont est amenée à un convertisseur (A/D) analogique/numérique, dont le signal numérique de sortie est utilisé pour commander le modulateur de largeur d'impulsions.

4. Dispositif de commutation selon la revendication 1 et 3, caractérisé en ce que le convertisseur analogique/numérique (A/D) est un convertisseur travaillant en intégration auquel est amenée, comme tension de référence, la tension d'équilibrage ($U_A$) s'effondrant sur la résistance d'équilibrage ($R_A$).

**Claims**

1. Circuit arrangement for balancing the measurement diagonal voltage of a resistance bridge circuit, in which at least one resistance element corresponding to a quantity to be measured is variable, a supply current is fed into a first bridge diagonal, and a signal corresponding to the quantity to be measured is measured at a second bridge diagonal, characterised by the following characterising features:
   a) the second bridge diagonal is opened at one of its two measurement points, and the gap (D, E) is bridged over with a balancing resistor ($R_A$);
   b) two electrically controllable switches (S1, S2) are each connected at one side to one of the end points of the balancing resistor, ($R_A$), and at the other side interconnected and connected to a deep pass (TP) and
   c) both switches (S1, S2) are alternately switched on and off in opposite senses by a digital control signal with adjustable mark-space ratio, wherein the mark-space ratio is a measure of the detuning of the resistance bridge circuit upon disappearance of the diagonal measurement voltage.

2. Circuit arrangement according to claim 1, characterised in that the mark-space ratio of the control signal is generated by a pulse-width modulator (PW).

3. Circuit arrangement according to claim 1 and claim 2, characterised in that the diagonal measurement voltage ($U_D$) present between the output of the deep pass (TP) and the other measurement point (C) of the second bridge diagonal is supplied to an A/D converter (A/D), the digital output signal of which it used for controlling the pulse-width modulator (PW).

4. Circuit arrangement according to claim 1 and 3, characterised in that the A/D converter (A/D) is a converter functioning by integration, to which the direct voltage ($U_A$) falling at the balancing resistor ($R_A$) is supplied as a reference voltage.

EP 0 215 190 B1